# EUROPEAN PATENT SPECIFICATION

(11) **EP 4 086 323 B1**
(45) Date of publication and mention of the grant of the patent: **22.05.2024**
(21) Application number: 21172494.3
(22) Date of filing: 06.05.2021
(51) Int. Cl.: C09K 11/66, C09K 11/68, C09K 11/77, H01L 33/50, H01L 25/16

(54) **LIGHT EMITTING DEVICE**
LICHTEMITTIERENDE VORRICHTUNG
DISPOSITIF ÉLECTROLUMINESCENT

(43) Date of publication of application: 09.11.2022
(73) Proprietor: Nichia Corporation, Anan-Shi Tokushima 774-8601 (JP)
(72) Inventor: WAKUI, Sadakazu, Anan-shi, Tokushima, 774-8601 (JP); MURAZAKI, Yoshinori, Anan-shi, Tokushima, 774-8601 (JP); SONTAKKE, Atul Dnyaneshwar, 3584 CM Utrecht (NL); VAN BUNNINGEN, Arnoldus Jacobus, 3584 CM Utrecht (NL); MEIJERINK, Andries, 3584 CM Utrecht (NL)
(74) Representative: V.O.

(56) References cited:
- DUAN YU ET AL: "Broadband Cr3+-sensitized upconversion luminescence of LiScSi2O6:Cr3+/Er3+", JOURNAL OF RARE EARTHS, vol. 39, 15 August 2020 (2020-08-15), pages 1181-1186, XP055851156, CN ISSN: 1002-0721, DOI: 10.1016/j.jre.2020.08.007
- XU XIAOXUE ET AL: "Highly efficient and thermally stable Cr3+-activated silicate phosphors for broadband near-infrared LED applications", CHEMICAL ENGENEERING JOURNAL, ELSEVIER, AMSTERDAM, NL, vol. 383, 9 October 2019 (2019-10-09), XP085971071, ISSN: 1385-8947, DOI: 10.1016/J.CEJ.2019.123108 [retrieved on 2019-10-09]
- LIU TIANYAO ET AL: "Efficient near-infrared pyroxene phosphor LiInGe 2 O 6 :Cr 3+ for NIR spectroscopy application", JOURNAL OF THE AMERICAN CERAMIC SOCIETY, vol. 104, no. 9, 19 April 2021 (2021-04-19), pages 4577-4584, XP055851160, US ISSN: 0002-7820, DOI: 10.1111/jace.17856 Retrieved from the Internet: URL:https://onlinelibrary.wiley.com/doi/fu ll-xml/10.1111/jace.17856>
- ZHOU XUFENG ET AL: "An Ultraviolet-Visible and Near-Infrared-Responded Broadband NIR Phosphor and Its NIR Spectroscopy Application", ADVANCED OPTICAL MATERIALS, vol. 8, no. 8, 23 February 2020 (2020-02-23), page 1902003, XP055851169, DE ISSN: 2195-1071, DOI: 10.1002/adom.201902003 Retrieved from the Internet: URL:https://onlinelibrary.wiley.com/doi/fu ll-xml/10.1002/adom.201902003>

## Description

### TECHNICAL FIELD AND BACKGROUND

The present disclosure relates to the generation of light, in particular light comprising broad band near infrared, NIR, radiation. The present disclosure further relates to a fluorescent material configured to convert light into NIR light, a light emitting device comprising said fluorescent material, and to a method of manufacturing said fluorescent material.

A main application of broad band NIR radiation is NIR spectroscopy (NIRS). NIRS is a powerful technique for characterization and analysis for a broad variety of samples, e.g. identification of chemicals and materials such as biological materials. Definite vibrational overtones of materials, e.g. chemicals, absorb one or more specific wavelengths. Comparing absorption data, e.g. to references or as a function of time, can give a clear indication of materials, e.g. type and quantity of chemicals, or transition of materials present in a measured sample. This method of identification offers a fast, non-destructive analytical tool. Furthermore, broad band NIR emission is relevant for bioimaging. Spectral changes, e.g. due to scattering and/or absorption of incident light due processes can be specific to the composition and microstructure of an analyzed object.

Known light sources with a broad band emission include incandescent sources, such as tungsten lamps, halogen lamps, and Globars. However, their application as broad band NIR irradiators typically remains limited in view of, e.g. low efficiency, large size, and/or short lifetime (typically < 5000 hours). Application may further be limited in view of cooling requirements, feedback demands, and/or requirements of such sources to be fitted with optical filters or monochromators to block specific unwanted or damaging parts of the emitted spectrum, e.g. UV/Vis radiation.

NIR light emitting diodes can offer several advantages over traditional incandescent sources. Typically, light emitting diodes offer higher energy efficiencies, smaller form-factor, and/or improved lifetime. However NIR light emitting diodes, such as CdSe, CdTe, GaAs, or InP, usually emit within a narrow spectral range, whereby the full width at half maximum (FWHM), e.g, of 850 nm LED, is typically around 35 nm [R. Pode, B. Diouf, Solar Lighting, Springer-Verlag, London, 2011]. Further drawbacks include poor overall thermal stability and thermal and/or operating current induced shifts, e.g. red-shifts, of the emission energy.

NIR phosphor converted light emitting diodes (pc-LED) have been disclosed as alternative for traditional NIR light sources. pc-LEDs typically comprise a suitable phosphor that converts at least part of the LED emission. In white light LEDs part of the blue to near UV emission from a InGaN LED is converted to light within the visible range of the spectrum (green-yellow-orange-red light).

Colloidal quantum dots like PbSe have been widely investigated as fluorescent materials for generating NIR light due to their tunable luminescence, high extinction coefficient, high internal quantum yield (up to 90 %), and broad band emission (FWHM > 200 nm) [L. Yan, X Shen, et al., RSC Adv. 5 (2015) 54109]. However, practical application of quantum dot based fluorescent materials typically remains limited, e.g. in view of limited long term stability and/or in view of limited external quantum efficiency (generally below 5 %), which is believed to be caused by non-radiative recombination or energy transfer between particles and reabsorption processes.

A number of NIR broad band emitting phosphors based on inorganic materials doped with transition metal has been reported. For example, Gao et al [Sci. Rep. 7 (2017) 1783] and Hughes et al in [Appl. Phys. Lett. 90 (2007) 031108] reported Ni²⁺-doped ZnGa₂O₄-based materials and V³⁺-doped chalcogenide glasses which show comparatively broad band emission (FWHM of ~300 nm) peaks with a maximum at around 1300 nm and 1500 nm, respectively. However, drawbacks such as low quantum efficiency and weak absorption in the blue spectral range hinder the application of such materials in NIR phosphor converted emitters based on blue to near UV InGaN semiconductor chips (NIR pc-LEDs).

Recently, Shao et al have reported prototype pc-LEDs that comprise phosphors based on YAl₃(BO₃)₄:Cr³⁺/Yb³⁺ and NaScSi₂O₆:Cr³⁺ [Q. Shao et al, Optics letters (2018) 43, 21, p5251-5254]. Xufeng Yu et al. demonstrated NIR emission from NaScGe₂O₆:Cr³⁺ and the incorporation in a pc-LED [X. Zhou et al., Adv. Optical Mater. (2020) 8, 1902003]. In [https://doi.org/10.1016/j.jre.2020.08.007] Yu Duan et al reported a LiScSi₂O₆:Cr³⁺-type phosphor. Although, upon excitation at 450 nm, YAl₃(BO₃)₄; NaScSi₂O₆, NaScGe₂O₆:Cr³⁺ and LiScSi₂O₆-based phosphors have been demonstrated to display emission within the NIR region of the electromagnetic spectrum there remains a need for improved emission characteristics, e.g. terms of peak position, broadness of the emission peak as well as in terms of internal and external quantum efficiency. Further examples of NIR emitting phosphors are known from Xiaoxue Xu et al., Chem. Eng. J. (2020) 383, 123108 and Tianyao Liu et al., J. Am. Ceram. Soc.(2021) 104, p.4577-4584.

The present disclosure aims to mitigate one or more of the above mentioned limitations and/or to provide devices and/or materials having improved emitting performance, e.g. in terms of (control over) emission peak position, peak broadness, and/or in terms of internal and external quantum efficiency.

### SUMMARY

The scope of this patent is defined by the independent claims. Aspects of the present disclosure relate to a light emitting device. The light emitting device comprises a light source. The light source is configured to emit blue to near UV light, preferably, having an emission maximum in a wavelength range below 550 nanometers, more preferably in a range between 400 and 525 nm, e.g. at about 450 nanometers. In addition the light emitting device comprises a fluorescent material according to the present disclosure. The fluorescent material is configured to, in use, absorb light emitted by the light source.

The fluorescent material may be associated, e.g. reversibly associated, with one or more light sources that are configured to emit blue to near UV light, e.g. in an array.

The fluorescent material is configured to convert, e.g. down convert, at least part of the light emitted by the light source into NIR light. Thus the light emitting device may be understood to display an emission, e.g. an emission peak, that is primarily within a wavelength range above 700 nanometers and below 2500 nanometers, e.g. having a peak emission above 750 nanometers, preferably between 780 and 1100 nanometers.

The fluorescent material comprises crystalline domains, e.g. microcrystalline domains, with a monoclinic lattice structure. The fluorescent material is doped with trivalent chromium and has a composition which may be represented with the structural formula:

Li₁₋ₓM^{I}ₓSc_{1-a-b}CrₐM^{II}_{b}(Si_{1-y}Ge_{y})₂O₆,

wherein "M^{I}" represents a monovalent alkali cation or mixture of monovalent alkali cations selected from the group consisting of Na and K, and wherein "M^{II}" represents at least one element selected from the group consisting of Ti, V, In, Ga, Y, Lu, Ce, Eu, La and Gd, wherein "a" and "b" each individually are 0.03 < a < 0.2, 0 ≤ b < 0.8, and wherein "x" and "y" each individually are 0.1<x<0.9, 0.1<y<0.9.

Compared to thermal incandescence-based emitters, devices as disclosed herein, e.g. comprising the fluorescent material according to the present disclosure, were found to display improved efficiency of emission within the NIR range in combination with the benefit of improved lifetime, and/or a possibility of a reduced form factor, e.g. by applying the fluorescent material as a coating onto a blue to near UV emitting LED such as a InGaN-LED.

Further, in comparison to NIR light emitting diodes, such as CdSe, CdTe, GaAs, or InP-based diodes, the devices and fluorescent materials according to the present disclosure were found to offer improved temperature stability (reduced temperature induced quenching or reduction of emission intensity). Also the devices and fluorescent materials according to the present disclosure were found to mitigate temperature induced peak shift, e.g. red shift.

Compared to NIR pc-LEDs based on YAl₃(BO₃)₄; NaScSi₂O₆ and LiScSi₂O₆-based emitters, e.g. as disclosed by Shao et al and Guan et al the fluorescent material and the light emitting device with the fluorescent material according to the present disclosure were found to offer improved broadness on the infrared emission (FHWM). Improved emission broadness, e.g. increased emission intensity within a portion of the NIR part of the electromagnetic spectrum may be particularly beneficial for spectroscopy and/or imaging applications. Additionally, the fluorescent material and devices according to the present disclosure were found to offer improved control or tunability over the energy of the emission maximum (control over peak maximum).

As will be explained in more detail hereinbelow both the advantages in terms of peak position and in broadness of the NIR emission were found to be related to the introduction of a suitable amount or disorder within in the lattice structure as comprised within the fluorescent material, which was found to correlate to the amount and type of substitutions (the composition of the solid solution) as provided by the fluorescent material as disclosed herein. Fluorescent materials lacking suitable disorder such as chromium doped fluorescent materials having a similar lattice structure where not at least part of one of the alkali and silicon ions is substituted were found to emit over a comparatively more narrow portion of the NIR part of the spectrum. Highly disordered fluorescent materials or even essentially amorphous fluorescent materials, such as chromium doped glasses are not preferred as the resulting emission, if any, was found to be subject to quenching at comparatively low temperatures, e.g. substantially below 150°C, e.g. at temperature of about 100°C or lower. Inventors found that the benefits to be absent for devices based on mixtures, e.g. binary mixtures, of otherwise unsubstituted chromium doped fluorescent materials (e.g. without solid solution comprising lithium and one or more alkali element and/or without solid comprising silicon and germanium).

Further or additional aspects of the present disclosure relate to a spectroscopy or imaging system. The system comprises the light emitting device according to the present disclosure and a NIR light detector configured to measure an intensity and/or spectrum of the infrared light (NIR) produced by the light emitting device, or an object illuminated by the light emitting device.

Yet further or additional aspects of the present disclosure relate to a method of manufacturing a light emitting device. The method of manufacturing the light emitting device comprises the steps of: preparing a fluorescent material, i.e. the fluorescent material as disclosed herein, and applying the prepared fluorescent material to form a device comprising a light source configured to emit blue to near UV light and wherein the applied fluorescent material is configured to convert the blue to near UV light into (near) infrared light.

Even further or additional aspects of the present disclosure relate to the fluorescent material as disclosed herein and to a process of manufacturing said fluorescent material. The process comprising the step of providing a mixture of precursor material powders for forming the chromium doped fluorescent material as described herein. The precursor material powders serving as source for the respective metal ions comprised in the fluorescent material. Said process further comprising the step of heating the mixture of precursor material powders at a temperature in a range between 1000 °C and 1400 °C to form the chromium doped fluorescent material.

Yet even further or additional aspects of the present disclosure relate to a method, or use of the fluorescent material according to the present disclosure, for generating infrared light. The method comprises exposing the fluorescent material as disclosed herein to blue to near UV light. By exposing the fluorescent material to blue to near UV light, e.g. using the light emitting device or system as disclosed herein, the emitted blue to near UV light is at least in part absorbed by the fluorescent material, the energy of which is released under emission of infrared light.

### BRIEF DESCRIPTION OF DRAWINGS

These and other features, aspects, and advantages of the apparatus, systems and methods of the present disclosure will become better understood from the following description, appended claims, and accompanying drawing wherein:
FIG 1A: schematically depicts a light emitting device during operation;
FIG 1B depicts a emission spectrum of a light emitting device;
FIG 2 depicts emission spectra of light emitting devices;
FIG 3A depicts emission spectra of fluorescent materials of different compositions;
FIG 3B depicts excitation spectra of fluorescent materials of different compositions;
FIG 4A illustrates the effect of composition on emission intensity;
FIG 4B illustrate the effect of adding flux on emission intensity;
FIGs 5A and 5B illustrate the effect of composition on the emission properties of fluorescent materials, on the width of the emission peak and the peak position;
FIG 6A depicts temperature dependent emission spectra;
FIGs 6B and 6C depict plots of the emission intensity as a function of temperature for fluorescent materials of different compositions;
FIGs 7A and 7B depict the temperature dependence of the emission life time of fluorescent materials of different composition;
FIGs 8A and 8B depicts X-ray diffractograms of fluorescent materials and solid solutions of fluorescent materials;
FIG 9A depicts the width of the emission peak for fluorescent materials of mixed composition and FIG 9B depicts the X-ray diffractograms of these materials;
FIG 10 depicts emission decay lifetime of fluorescent materials at varying emission wavelengths.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The term "fluorescent material" as used herein may be understood to relate to a phosphor, or in general terms to a substance that exhibits the phenomenon of luminescence; it emits light when exposed to some type of radiant energy. When a phosphor is exposed to radiation, electrons in its structure, e.g. in molecules or optically active ions, are excited to a higher energy level from which they return under emission of a photon (light) of a certain energy (color).

Infrared radiation or emission may be understood to relate to radiation that extends from the nominal red edge of the visible spectrum at about 700 nanometers (nm) to about 1 millimeter (mm). The term "near infrared or NIR light emission" as used herein is typically subdivided in "IR-A" and "IR-B" according to DIN 5031. IR-A, generally refers to the subrange characterized by wavelengths from about 700 or 650 nanometers, typically 750 or 780 nanometers up to and including 1400 nanometers. IR-B generally refers to the subrange from about 1400 nanometers to about 3 micrometers. Depending on context either IR-A or the combined range of IR-A and IR-B may be referred to as near-infrared (NIR) radiation. In the context of the present disclosure near infrared spectroscopy may be understood to particularly relate to the IR-A range, and in particular to materials having maximum emission in the range between 750 and 900 nanometers.

NIR radiation in the 700 - 1300 nm wavelength range (commonly known as optical window) is known to show the highest depth of penetration into biological matter. This spectral region is very useful for non-invasive imaging of biological samples, for instance in optical coherence tomography (OCT). OCT is a technique that can deliver cross-sectional images of tissue layers on the micron scale in situ and in real time.

The term "blue to near UV light" as used herein may be understood to relate to emission, e.g. a spectrum, having a maximum centered around a maximum absorption peak of the fluorescent materials as described herein, which is typically about 450 nanometers, e.g. in a range between 400 and 550 nanometers. Emission in the blue to near UV range may be understood to include emission of light having a wavelength in a range between about 300 nanometers to about 485 or 500 nanometers. Blue to near UV light may be provided by any source having suitable emission characteristics. As described herein blue to near UV emitting InGaN light emitting diodes may be particularly suitable for exciting the fluorescent materials according the present disclosure. InGaN LEDs or indium gallium nitride (InGaN) LEDs are a well-known type of light emitting diodes that include a semiconductor material made of a mix of gallium nitride (GaN) and indium nitride (InN).

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

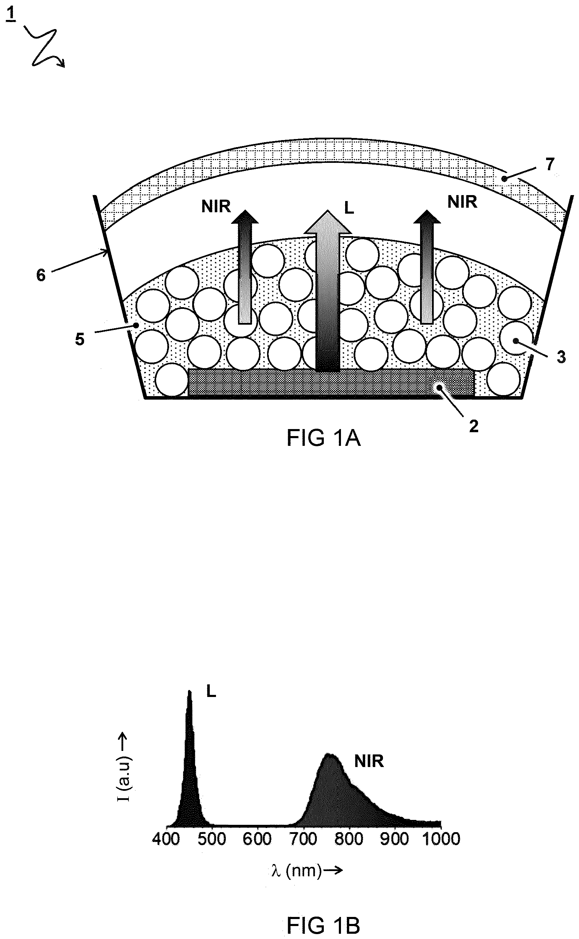

FIG 1A depicts a cross-section side view of a light emitting device 1 according aspects of the present disclosure. The light emitting device, e.g. as shown, comprises a light source 2. In some embodiments the light source is provided at the bottom of a cavity or substrate 6. Alternate positions, e.g. below a transparent window, are also envisioned. Provided above or onto the light source 2 is a coating comprising particulates of a fluorescent material 3 within a matrix 5. In some embodiments, e.g. as shown the light emitting device 1 is further provided with a filter or mirror 7 configured to allow the infrared light (NIR) to pass while reflecting or absorb at least part of the blue to near UV light. Details to this optional filter or mirror are provided below.

The light source is configured to emit blue to near UV light L, preferably, having an emission maximum in a wavelength range below 550 nanometers, more preferably in a range between 400 and 525 nm, e.g. at about 450 nanometers. In addition the light emitting device 1 comprises a fluorescent material 3. Typically the light source 2 is integrated into the light emitting device 1, e.g. as shown. Alternatively the light emitting device may be formed of a system comprising a fluorescent material that can be associated, e.g. reversibly associated with one or more light sources that are configured to emit blue to near UV light, e.g. in an array.

The fluorescent material 3 is preferably comprised within a coating which is provided onto the light source 2. Details regarding the composition and manufacture of the fluorescent material 3 will be described in more detail hereinbelow. The coating comprises a powder of the fluorescent material 3 and a matrix 5. The matrix 5 is configured to transmit (be transparent for) at least part, preferably at least 90%, preferably essentially all, of the radiation within the corresponding excitation and emission bands. Preferably, the coating comprises a silicone matrix. Typically the coating comprises between 20 and 80 percent by weight of the coating material, e.g. about 50 or 60 wt%. The higher the loading the more NIR light that can be generated. Silicones may be processed relatively easily and are known to combine suitable transmittance properties with protective properties, shielding the fluorescent material 3 from external influences which may negatively affect the properties of the fluorescent material over time, such as humidity. In some embodiments, the coating is to be formed before being applied to the light source. Preferably, the coating is applied in liquid form and hardened on the light source, e.g. by forming a mixture, e.g. a suspension, comprising a suitable precursor to the silicon matrix and an amount of the prepared fluorescent material, preferably in the form of a microparticulate. Applying the coating to the light source 2 in liquid form ensures complete coverage and/or intimate contact between coating and light source 2. Alternatively, the fluorescent material may be applied as a pellet formed of compressed powder.

Preferably the fluorescent material 3 is provided in the form of a micrometer scale powder. A micrometer scale powder can be understood as a powder wherein at least 90 %, by number, of the particles having a maximum cross-section diameter in a range between 1 and 20 µm. Typically particles having a maximum diameter in a range between 5 and 20 micrometers are preferred, e.g. in view of handling and/or reproducibility and homogeneity of the distribution of the fluorescent material on the light source configured, e.g. within the coating.

Preferably, the light source 2 is a light emitting diode. As such, the light emitting device 1, e.g. as shown, may be understood to be arranged as a phosphor converted LED (pc-LED). Preferably, the LED is a blue to near UV emitting InGaN semiconductor chip. InGaN LEDs are well known for a combination of good lifetime (>30000 hours) and highly efficient emission of light in the blue to near UV part of the electromagnetic spectrum, e.g. having an emission maximum at about 450 nanometers. In pc-LEDs for white light generation a LED chip is coated with a phosphor converter that partially or fully converts the blue to near LED emission to longer wavelength green-yellow-orange-red light. In the light emitting device 1 according to the present disclosure a similar concept is applied to generate broad band NIR radiation, e.g. by converting the blue to near UV InGaN emission with a fluorescent material 3 or phosphor configured to emit broad band NIR radiation.

FIG 1B displays an exemplary emission spectrum of a NIR phosphor converted LED including a blue to near UV emitting LED and a ceramic pellet comprising Gd₃Sc₂Ga₃O₁₂:Cr³⁺ µm-scale powder converter. Note that this composition is not according to the present disclosure. The emission spectrum consists of two parts, one in the blue to near UV range (primary LED light) and one in the NIR region (due to near UV to blue to NIR fluorescent), whereby a comparatively large fraction of the blue to near UV light L is transmitted through the coating.

As will become more clear from the discussion and experimental details below the fluorescent material according to the present disclosure is configured to convert, e.g. down convert, at least part of the light emitted by the light source into NIR light. Thus the light emitting device may be understood to display an emission, e.g. an emission peak, that is primarily within a wavelength range above 700 nanometers and below 2500 nanometers, e.g. having a peak emission above 750 nanometers, preferably between 780 and 1000 nanometers.

The fluorescent material 3 according to the disclosure, e.g. as shown in FIG 1A, typically is in the form of a micrometer scale powder or particulate. The fluorescent material is doped with trivalent chromium and has an overall composition which may be represented with the structural formula:

Li₁₋ₓM^{I}ₓSc_{1-a-b}CrₐM^{II}_{b}(Si_{1-y}Ge_{y})₂O₆,

wherein "M^{I}" represents at least one element selected from the group consisting of Na and K,, and wherein "M^{II}" represents at least one element selected from the group consisting of Ti, V, In, Ga, Y, Lu, Ce, Eu, La and Gd. The values for "a" and "b" are each individually 0.03 < a < 0.2, 0 ≤ b < 0.8, and "x" and "y" each individually are 0.1<x<0.9, 0.1<y<0.9.

In general terms the fluorescent material as characterized by its overall structural formula may be understood as a chromium doped ceramic having an alkali scandium silicate-type lattice structure wherein at least part of the respective metal ions within the lattice is substituted for an alternate, chemically similar, ion with the same valence.

In principle any one or more of the metal ions within the lattice may be substituted with one or more corresponding metal ions. Also the molar ratio between the element and its one or more substitutes can vary over a broad range, generally all the way within the disclosed ranges for "a", "b", "x", and "y", so long as the compound essentially remains organized in a monoclinic lattice structure.

In general terms, the fluorescent material according to the invention may be referred to as a solid solution of a chromium doped host compound, the doped host compound having an alkali-rare earth element-silicate-type lattice structure. Within the structure elements of one or more lattice positions are preferably replaced by similar elements. As to the silicon/germanium positions and/or to the alkali positions the doped host compound may be understood to comprise a solid solution of the specified elements.

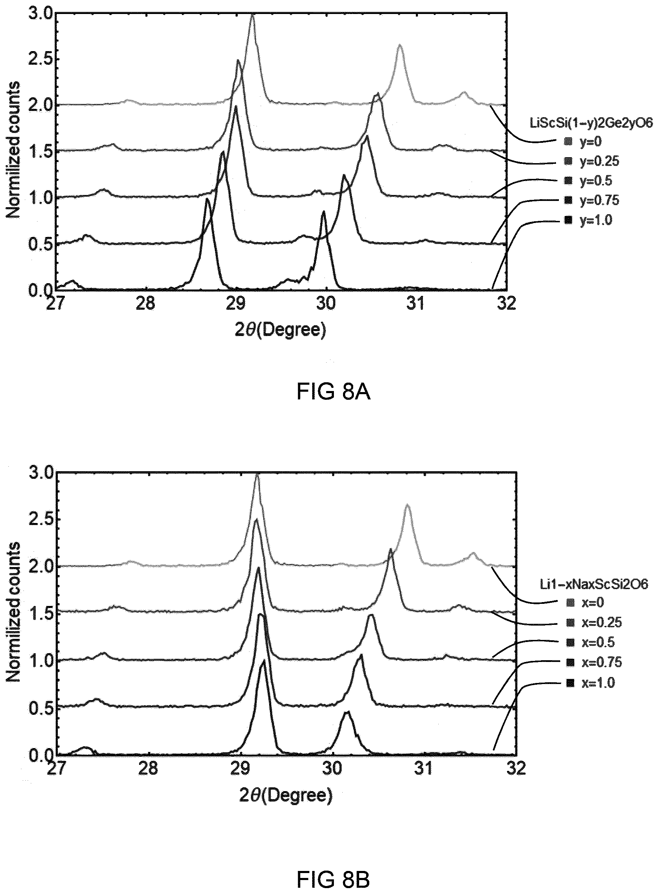

The doped fluorescent material may be understood to be arranged in a monoclinic lattice structure as can verified by XRD diffractometry, e.g. as shown in FIGs 8A and 8B. Preferably, at least ninety percent by weight or more, e.g. ninety five or ninety nine weight percent of the fluorescent material has a monoclinic lattice structure. Most preferably essentially all of the fluorescent material is in a monoclinic lattice structure as may be confirmed, e.g. a by an absence of scattering peaks not related to the crystal structure.

Both the advantages in terms of peak position and in broadness of the NIR emission as compared to known phosphors were found to relate to the introduction of a suitable amount or disorder within in the lattice structure as comprised within the fluorescent material.

As to the mechanism behind the observed improvements in optical properties of the fluorescent material according to the present disclosure inventors find that cation substitution results in solid solutions in which the crystal structure is preserved. The LiScSi₂O₆ crystal structure has three cation sites in which substitution is possible. The Li⁺ can be substituted by other monovalent cations such as Na⁺ or K⁺, The Sc³⁺ ion can be substituted by other trivalent cations such as Ti³⁺, V³⁺, Ga³⁺, In³⁺, Y³⁺, Lu³⁺, Ce³⁺, Eu³⁺, La³⁺ and Gd³⁺ while the Si⁴⁺ ion can be substituted by Ge⁴⁺. Partial substitution of a cation is found to result in solid solutions in which there is disorder in the distribution of the cations. For example, in an exemplary fluorescent material with a composition of Li_{0.6}Na_{0.4}ScSi₂O₆ disorder in the lattice is introduced because of occupation of the monovalent cation sites by either Na⁺ or Li⁺. In a similar manner, in LiSc(Si_{0.5}Ge_{0.5})₂O₆ disorder is introduced by the occupation of the tetravalent lattice positions by either Si⁴⁺ or Ge⁴⁺. This disorder results in a variation of the local surroundings of Cr³⁺ ions which is believed to affect the emission wavelength of the Cr³⁺. The emission wavelength of the broad band NIR emission of Cr³⁺ is believed to be determined by the crystal field splitting which is known to vary depending on the local coordination. Because of the disorder in the local surrounding induced by differences in occupation of the cation sites, the emission wavelengths will be different for Cr³⁺ ions in different places in the crystal lattice, which is believed to result in additional inhomogeneous broadening and to a larger FWHM of the NIR emission band. It will be appreciated the disorder effects by cation substitution at one lattice position as described herein may further modified by further substitutions, e.g. at two or more lattice positions and/or by introduction of multiple different ions at a single position.

Inventors found the inhomogeneous broadening (the FWHM) of the NIR emission band increases with increasing level of disorder within the lattice and as such depends on the levels of cationic substitution. As such, starting from compound with zero substitution at the alkali position, e.g. LiSc_{0.95}Cr_{0.05}Si₂O₆, the NIR emission band was found to initially broaden upon increasing levels of substitution, e.g. to Li_{0.8}Na_{0.2}Sc_{0.95}Cr_{0.05}Si₂O₆. Towards the other end of the scale the effect was found to decrease again.

The amount of chromium, possibly in combination with other dopants may vary, e.g. in dependence of an envisioned application. Typically, the trivalent chromium dopant is provided in a molar ratio ("a"), relative to the total of scandium, chromium and other metal ions M^{II} if any, in a range below 0.2. In some embodiments, the range is below 0.1. Preferably "a" is at least 0.01".Typically "a" is in a range between 0.03 and 0.2, such as 0.05 (5 at%) or 0.08 (8 at%). Inventors found emission efficiency initially continuously increases with the increasing amounts of chromium that are incorporated within the lattice as absorption of emitted blue to near UV light increases continuously with increasing Cr³⁺ content. For fluorescent material wherein the chromium level is about 0.05 absorption of blue to near UV light (monitored 450 nm) was found to be about 50%. However, in practice, for levels above 0.2 (20 at%) overall emission intensity within the NIR range was found to decrease. Inventors find this decrease in emission intensity (concentration dependent extinction) relates to an increased likelihood of energy transfer between neighboring Cr³⁺ ions. At about 20 at% Cr levels emission loss due to energy transfer to quenching centers was found to outweigh emission benefits due to increased excitation due to absorption of blue to near UV light.

With regard to the relative amounts of specific cations and the corresponding cationic substituents comprised in the solid solutions according to the invention inventors found that the disorder and the accompanying effect on broadness of the emission peak increases towards compositions (solid solutions) with about equimolar composition, e.g. compositions wherein "x" is between 0.3 and 0.8. It will be understood that disorder decreases for solid solutions wherein the one or more substituents are provide in small or very large ratios, e.g. about 0.1, e.g. for compositions comprising close to 10 or 90 at% of lithium.

As to "x", it is noted that "x" can in principle vary between 0 and 1. The NIR emission band was found to be broadest for composition ion wherein "x" tends towards the center of the range. Accordingly, in a preferred embodiment, x is between 0.1 and 0.9. More preferably, x is in a range between 0.2 and 0.8, even more preferably x is between 0.4 and 0.7, e.g. about 0.45. Most preferably x is between 0.5 and 0.6, e.g. about 0.5 or 0.55.

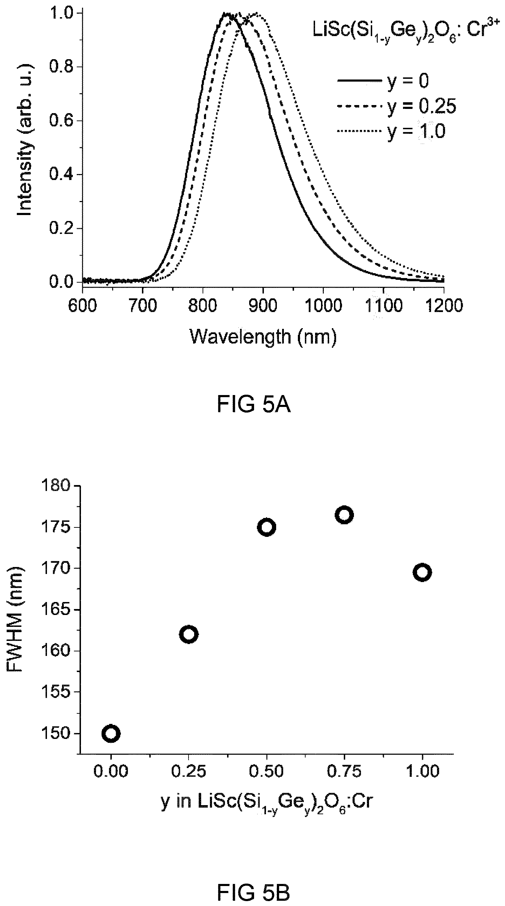

As to the molar fraction "y" of germanium (Ge) inventors found that Si and Ge are in principle interchangeable in all ratios. In some embodiments the structure comprises 100 atom% Si, whereas others comprise 100 atom% Ge (relative to the total of Si and Ge). Note that, as illustrated in FIG 5B, the NIR emission band for compounds with 100% Ge, e.g. LiScGe₂O₆ was found to be more than 10% broader as compared to chromium doped compounds with 100% Si, e.g. compounds having an overall composition of LiSc₁₋ₙCrₙSi₂O₆ sometimes represented as LiScSi₂O₆:nCr. Similar as to for alkali-substituted compositions emission band broadening was found to be broadest near the center of the range. Accordingly, in some preferred embodiments, "y" is between 0.1 and 0.9, more preferably between 0.2 and 0.9, even more preferably between 0.4 and 0.8, e.g. about 0.5, 0.6 or 0.7.

Similar to alkali and/or Si/Ge substitution the effect on NIR emission and broadening was found to increase with increasing levels of substitution at the trivalent metal position (M^{II}). As to the molar fractions of scandium "1-a-b", chromium "a" and the one or more trivalent cations other than chromium "b" it is noted in practice compounds with high levels of substitution at the trivalent metal position, e.g. compounds wherein "1-a-b" is below 0.2 may have reduced crystallinity and/or include lattice structures other than the monoclinic lattice structure. Accordingly, the level of scandium (1-a-b) is not lower than 0. Typically "a+b" is in a range between 0.2 and 0.8, preferably 0.2 and 0.6, more preferably between 0.4 and 0.6, e.g. about 0.45, 0.5 or 0.55. The level of M^{II} within the fluorescent material can be essentially zero. Generally 0 ≤ "b" < 0.8. Typically "b" does not exceed 0.4.

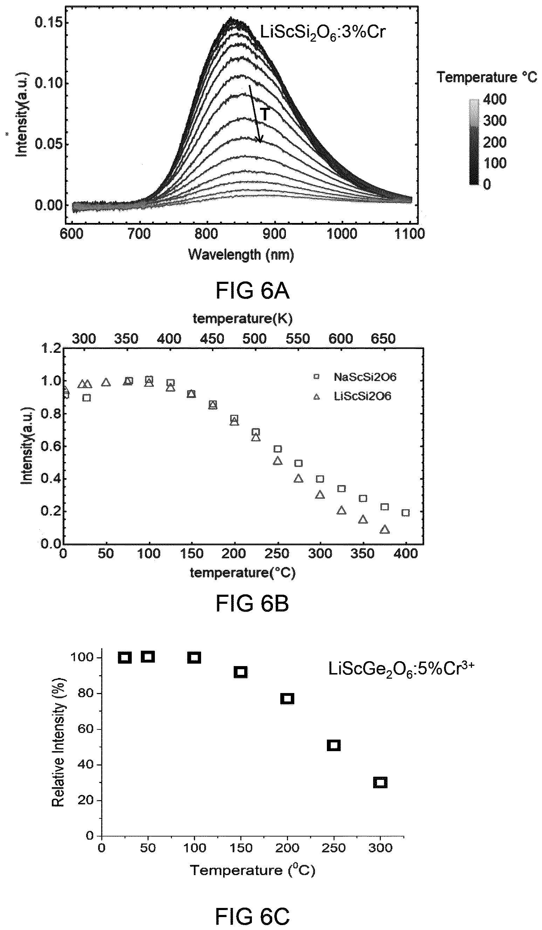

Devices comprising highly disordered conversion materials or even essentially amorphous conversion materials, such as chromium doped glasses are not preferred as the resulting emission, if any, was found to be subject to quenching at comparatively low temperatures, e.g. substantially below 150°C, typically at a temperature of about 100°C or lower. In contrast, compounds according to the present disclosure were found to be more stable. As illustrated in FIG 6A, emission intensity was found to remain stable (within 90%) up to temperatures of 150°C. In addition only a minor red-shift (below about 10 nm) was observed for the emission energy (peak position) when changing the temperature from room temperature (RT) to 150°C.

Further or additional aspects of the present disclosure relate to a spectroscopy or imaging system. The system typically comprises the light emitting device 1 according to the present disclosure and a NIR light detector configured to measure an intensity and/or spectrum of the infrared light (NIR) produced by the light emitting device, or an object illuminated by the light emitting device. In a preferred embodiment, wherein the system comprises a spectral resolving element, such as a grating or prism, configured to receive NIR light from an object illuminated by the light emitting device, and project a spectrum of the received NIR light onto the NIR light detector, e.g. onto a pixel array of the detector, e.g.. In another or further preferred embodiment, the system comprises a plurality of laterally spaced the light emitting devices as disclosed herein. Including one or more laterally spaced NIR emitters allows larger objects to be illuminated and/or imaged and/or increases overall illumination intensity.

Yet further or additional aspects of the present disclosure relates to a method of manufacturing a light emitting device 1, a process of manufacturing the fluorescent material, preferably a trivalent chromium doped fluorescent material as obtainable by the process described herein.

The method of manufacturing a light emitting device comprises the steps of: preparing a fluorescent material 3, i.e. the fluorescent material as disclosed and/or as obtained by the method of preparing a fluorescent material as disclosed herein. Subsequently the prepared fluorescent material is applied onto a light source to form a light emitting device, wherein the light source is configured to emit blue to near UV light (L) and wherein the applied fluorescent material 3 is configured to convert the blue to near UV light into (near) infrared light (NIR).

In a preferred embodiment, e.g. as shown and described in relation to FIG 1A, the fluorescent material is applied as a coating onto the light source (e.g. a InGaN diode), preferably a silicone based coating. In another or further preferred embodiment, e.g. as shown in FIG 1A, the light emitting device 1 further comprises a low pass filter or mirror 7 configured to allow the infrared light (NIR) to pass while reflecting or absorb at least part of the blue to near UV light L, e.g. at least ninety percent of incoming NIR light is passed through, while less than ten percent of incoming blue to near UV light passes through. To minimize emission efficiency losses the low pass filter or mirror preferably is arranged to minimized absorption, preferably to absorb less than five percent or below one percent of the blue to near UV and NIR light. In some embodiments the low pass filter or mirror 7 is applied as a separate layer or window, e.g. directly onto or above the coating. Alternatively, or in addition, the low pass filter or mirror may be comprised within the coating, e.g. as particulates. Addition of a low pass filter or mirror can improve the overall absorption of blue to near UV light within the system.

The fluorescent material 3 is prepared in a solid synthesis process comprising: providing a mixture of precursor material powders for forming the chromium doped host compound as described herein. Typically each of the precursors is a source for one of the cations comprised in the fluorescent material, e.g. a metal oxide. It will be understood that alternatively, or in addition, at least part of the cations may be provided from a multicomponent precursor, e.g. an alloy or blend. After providing the mixture is exposed to a firing step wherein the mixture of precursor material powders is heated at a temperature in a range between 1000 °C and 1400 °C for a time suitable to form the chromium doped fluorescent material 3. The required time can be determined experimentally, e.g. from XRD. Typically the reaction is finished within a period between 1 and 12 hours, or more, e.g. up to a day, typically between 2 to 6 hours.

Heating is typically performed under presence of oxygen, e.g. ambient air. Alternatively heating can be formed under inert atmosphere, e.g. N₂ or Ar. Heating under oxygen may be preferred as contaminations, e.g. organic contaminations may be removed (burnt) from the mixture.

Suitable precursors materials include oxides and/or hydroxides of the respective elements, such as alkali oxides or hydroxides, chromium oxide, scandium oxide, silicon oxide and germanium oxide. Alternatively or/in addition, the precursor materials may be selected from the groups of oxalate or carbonate salts of the respective elements or other salts having a volatile counterion at temperatures above 1000°C. Suitable examples include oxalates, halides such as chlorides and fluorides. A typical precursor mixture comprises Na₂CO₃, Li₂CO₃, SiO₂, Cr₂O₃ and Sc₂O₃. Typically the precursor materials are weighed in or added to the mixture in a stoichiometric amount based on a relative abundance of the respective cations in the fluorescent material 3. Small deviations, e.g. up to 1 or 5 wt% may be tolerated. It will be understood that the type and amount of precursors may be adjusted, e.g. for embodiments wherein other elements are to be comprised within the lattice structure, e.g. solid solutions with Si/Ge and/or Sc and one or more other metal ions as described herein.

Preferably, the precursor compounds are provided as powders or microparticulates, wherein at least 90%, by number has a maximum cross-section diameter below one hundred micrometer or less, e.g. below twenty micrometer. Providing the precursors as powders was found to reduced reaction times and to improve homogeneity of element distribution within the solid solutions formed. More intimate mixing can be achieved by grinding or milling the mixture, e.g. by ball grinding. Alternatively or in addition, at least part of the precursors may be pre ground or milled. Reducing the size of the precursors was found to improve homogeneity of the formed fluorescent material 3. Said improvement is believed to relate to reduced diffusion lengths for the elements to be incorporated into the lattice structure.

Advantageously, the process of preparing the fluorescent material 3 as disclosed herein was found to yield predominantly monoclinic and homogeneous microparticles. Preferably, the majority each of the microparticles has an essentially homogeneous monoclinic lattice structure. As explained above glassy fractions and/or multi-phase compositions were found to reduce emission efficiency and/or reduce temperature stability. In some embodiments, the method includes separating the formed mixture of microparticles into one or more of the preferred dimensional ranges as described in relation to the emitter. Separation may be based on mass and/or dimension. Proper methods are known to the skilled person and include filtration and/or centrifugation.

To improve the crystallinity and particle size, a flux agent is added. Flux agents that have been used include alkali halides such as LiF, LiCl, NaF, NaCl, H₃BO₃, molybdate, and tungstate fluxes. Accordingly, in some preferred embodiments, a flux is added to the mixture of precursors. A flux may be understood as a material that does not partake in the overall reaction but that improves reaction process. Generally, a flux is material that has a melting temperature below the heating temperature used in the process. Commonly, it is believed that improved reaction processes can be associated improved mobility of metal cations due to a solubility of the one or more of the precursor materials in the molten flux phase. Generally the flux is added in an amount in a range between 5 or 10 and 50 at%, based on the total weight of the reaction mixture at the start of the reaction. Use of fluxes comprising a metal ion to be comprised in the lattice structure, such as LiF, NaF, KF, NaCl, KCl, and LiCl, may be particularly preferred as these salts can be understood to constitute a reactive flux, that serves a double function of flux and precursor. In contrast to flux additives in the conventional sense reactive flux is added in a slight excess, typically about 5-15 at % over a required stoichiometric amount. The excess compensates for possible evaporation losses during the heating step.

To further improve the crystallinity and particle size, a modified heating procedure can be applied that involves two heating steps including an initial preheating step to pre decompose at least part of the precursor compounds comprised in the mixture. In a preferred embodiment, the process for preparing the fluorescent material comprises an initial firing step, prior to the firing step, wherein the mixture of precursors is heated to a temperature in a range between 700 °C and 1000 °C. In another or further preferred embodiment, the method comprises an intermediate grinding step following the initial firing step and prior to the main firing step. An additional step to reduce the size of the particles within the mixture and/or to improve the homogeneity in between the firing steps was found to further improve the crystallinity and particle size distribution.

In some preferred embodiments, the crystallinity and/or particle size distribution is further optimized by using precursor materials that are more reactive, such as nanosized SiO₂ and/or GeO₂ particles as source for Si and Ge respectively and/or by using oxalates or carbonates, such as Sc-oxalate as source for Sc and/or Cr-oxalate as source for Cr. Improved reactivity of nanosized particles and/or oxalate-based precursor material is believed to be due to reduced melting and decomposition temperatures respectively. Increasingly smaller particles were found increasingly favor homogeneity of the formed product, e.g. as to the distribution of metal ions within the solid solution. In a preferred embodiment, silicon and/or germanium precursors are provided as nano particulates. Preferably, at least 90%, by number, of the nanoparticulates has a maximum cross-section diameter below one micrometer, preferably below 100 nanometers or lower, e.g. in a range between about ten and fifty nanometer.

For the purpose of clarity and a concise description, features are described herein as part of the same or separate embodiments, however, it will be appreciated that the scope of the invention may include intermediate products, and/or embodiments, e.g. systems having combinations of all or some of the features described. For example, while embodiments were shown for a light emitting device comprising a light source and a fluorescent material, also alternative ways may be envisaged by those skilled in the art having the benefit of the present disclosure for achieving a similar function and result. E.g. the light source and fluorescent material may combined or split up into one or more alternative components. It will be understood that fluorescent material as disclosed herein can be used to provide light emitting devices that substantially, or even exclusively, emit light in the NIR region. However, it will be appreciated that the invention is not limited thereto. Aspects of the present invention, e.g. the fluorescent material or blue to near UV emitters, may be combined with other emitters and/or fluorescent materials, which allows provision of devices arranged to emit within a desired spectral range. The various elements of the embodiments as discussed and shown offer certain advantages, such as improved efficiency and/or improved broadness of the emission peak. Of course, it is to be appreciated that any one of the above embodiments or processes may be combined with one or more other embodiments or processes to provide even further improvements in finding and matching designs and advantages.

Aspects relating to the light emitting device, the fluorescent material 3, and the methods of manufacturing the emitter and/or the fluorescent material will now be elucidated by the following non-limiting examples.

### EXAMPLES

Inventors have prepared and tested a broad range of fluorescent materials using the solid synthesis process as described herein.

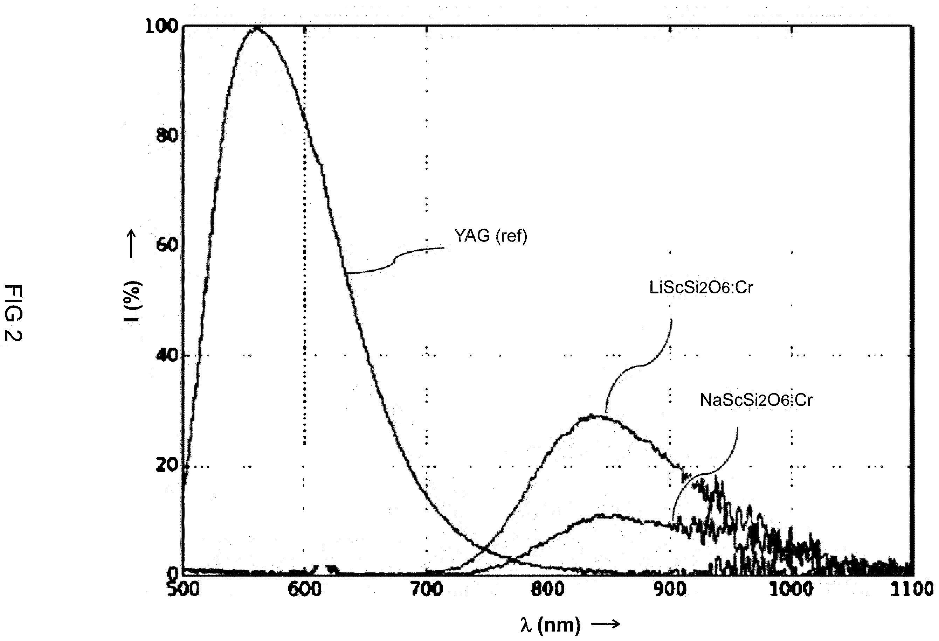

FIG 2 compares emission spectra of a light emitting device comprising a known YAG-type fluorescent material, such as disclosed in S. Ye et al., Materials Science and Engineering R 71 (2010) 1-343, to similar devices comprising fluorescent materials according to the present invention. As can be seen emission for exemplary devices comprising LiScSi₂O₆:Cr and NaScSi₂O₆:Cr is more pronounced in the NIR region, in particular in a range from about 700 to 1000 nm.

The Table below summarizes measured luminescence properties of the LiScSi₂O₆:5%Cr³⁺ NIR phosphor, LiScGe₂O₆:5%Cr³⁺ NIR phosphor and NaScGe₂O₆:5%Cr³⁺ NIR phosphor and solid solutions in comparison to a reference phosphor, including the position of the emission maximum (λₑₘ), the internal quantum efficiency (IQE), the external quantum efficiency (EQE) and the percentage of blue to near UV (Ga,In)N light that is absorbed (Abs%).

| **Composition** | **IQE** | **EQE** | **Abs%.** | ***λ* _{em,p}** | **fwhm** |
|---|---|---|---|---|---|
| LiScSiGeO₆:Cr³⁺ | 52 | 31 | 60 | 873 | 175 |
| LiScGe₂O₆:Cr³⁺ | 54 | 32 | 60 | 890 | 169 |
| LiScSi₂O₆:Cr³⁺ | 78 | 45 | 58 | 840 | 150 |
| NaScSiGeO₆:Cr³⁺ | 33 | 16 | 49 | 885 | 167 |
| NaScGe₂O₆:Cr³⁺ | 46 | 22 | 50 | 900 | 166 |
| Y₃Al₅O₁₂:0.5%Ce³⁺ | 96 | 69 | 72 | 559 | |

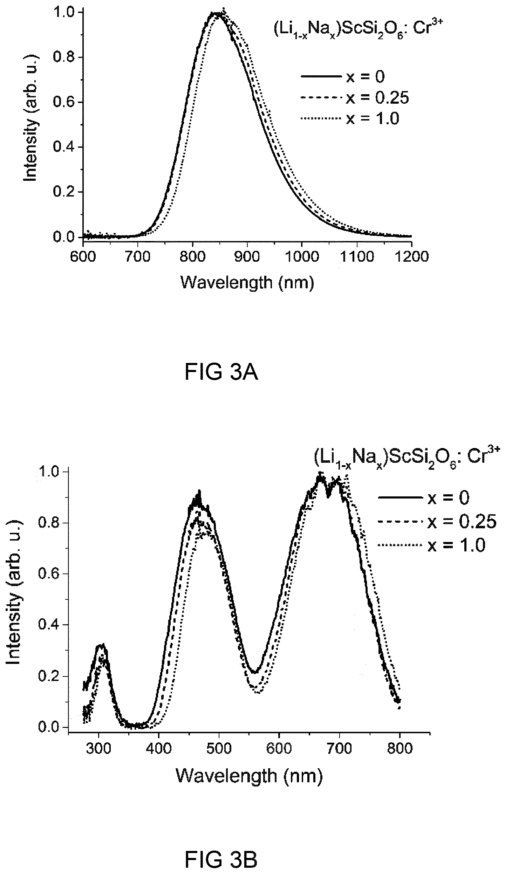

The emission spectra of NaScSi₂O₆:5%Cr³⁺ and LiScSi₂O₆:5%Cr³⁺ at room temperature show a broad emission peak centered around 855 nm for the sodium scandium silicate and around 840 nm for the lithium scandium silicate. The Full width half max (FWHM) of these compounds at room temperature is 0.25 eV (2000 cm⁻¹ or 150 nm). Excitation spectra were taken from the 850 nm emission. In the excitation spectra, three transitions can be assigned to peaks (see FIG 3B). The ⁴A₂→⁴T₁(⁴P), ⁴A₂→⁴T₁(⁴F) and ⁴A₂→⁴T₂ belong respectively to the peaks at 320 nm, 480nm and the double peak at 690 nm. A small shift to higher wavelengths can be seen for the LiScSi₂O₆ hosts, which is in correspondence with the shift seen in the emission spectra.

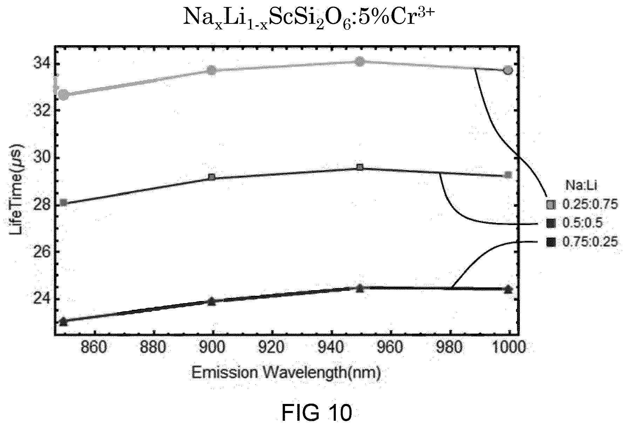

To confirm that emission is measured from the same phase and that no phase segregation occurs in the mixed Li-Na fluorescent materials, emission decay measurements were performed at four different emission wavelengths. These decay curves were then fitted with a mono-exponential fit. Results of the lifetime of exemplary measurements are shown in FIG 10. The lifetime was found to be more or less constant over the four different emission wavelengths. The trend that with increasing sodium content the lifetime drops is in accordance with the measured emission lifetimes for Cr³⁺ emission in the pure compounds, which is about 48 µs for LiScSi₂O₆ and 23 µs NaScSi₂O₆. Deviations from these trends can be can indication for solid solutions having a less homogeneous composition, e.g. a multiphase structure or local cation disorder.

The thermal properties of the compositions according to the invention have been evaluated by measuring temperature dependent quenching of their NIR emission. FIG6A illustrates the temperature dependence of emission intensities for an exemplary LiScSi₂O₆:3%Cr³⁺ composition. The thermal quenching behavior shows excellent thermal stability of the emission intensity and a quenching temperature above 200°C. The plots depicted in FIGs 6B and 6C depict normalized emission intensity at maximum emission as function of temperature for LiScSi₂O₆:3% Cr³⁺; NaScSi₂O₆:3%Cr³⁺; and LiScGe₂O₆:5%Cr³⁺. All solid solutions, also those with mixtures of alkali metals and or Si/Ge, were found to have a similar excellent temperature stability. Intensity was found to be stable up to 125°C before dropping to the T₅₀ at 250°C and 275°C for LiScSi₂O₆ and NaScSi₂O₆, respectively.

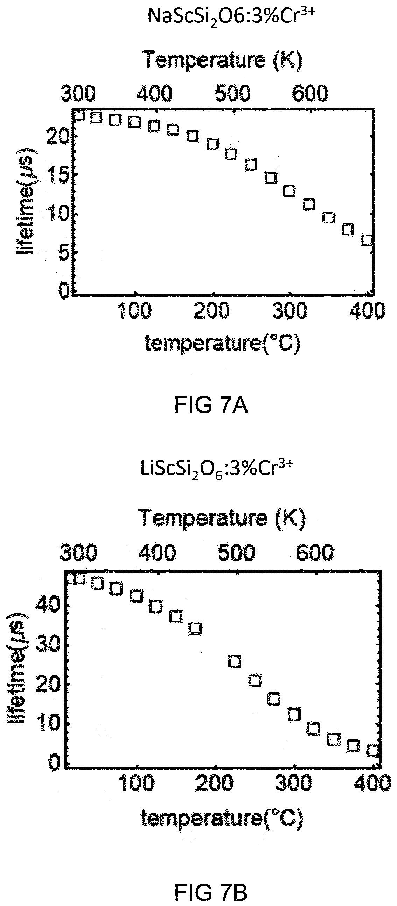

To evaluate emission efficiency (IQE) as a function of temperature, emission decay curves were measured at temperatures ranging from 4 to 725 K. The obtained curves reveal mono exponential behavior. FIGs 7A and 7B depict respectively exemplary curves for NaScSi₂O₆:3%Cr³⁺ and for LiScSi₂O₆:3%Cr³⁺ of the temperature dependence of the decay time. It can be seen that for both types of host materials, a decrease in lifetime is seen above 400 K. This drop coincides with the drop in emission intensity seen in FIGS 6A, 6B and 6C. This further confirms the excellent thermal stability of the emission and the high thermal quenching temperature of the NIR emission for these fluorescent materials.

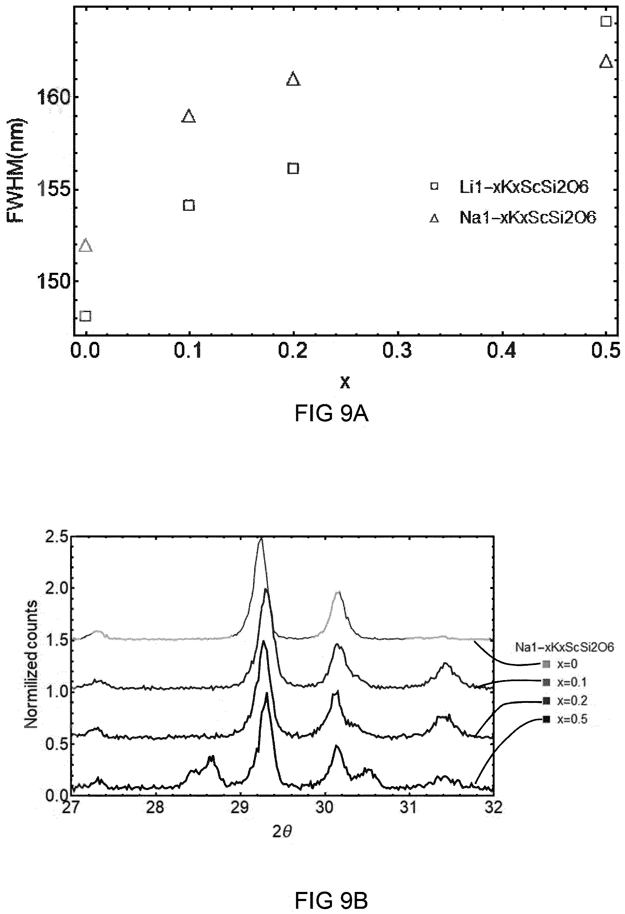

FIGs 8A and 8B displays X-ray diffractograms of LiScSi_{(1-y)2}Ge_{2y}O₆:5%Cr³⁺ NaₓLi₁₋ₓScSi₂O₆:5%Cr³⁺ solid solutions, wherein y and x are varying from 0 to 1. All compounds were obtained as particulates with essentially homogeneous composition as can be determined from the subtle and continuous shift of the XRD peaks, from 28.7° 2θ and 30° 2θ to 29.2° 2θ and 31° 2θ for LiScSi_{(1-y)2}Ge_{2y}O₆:5%Cr³⁺in Fig. 8A. Splitting of the peaks, would be an indication of formation a multi-phase compound and is not observed, providing evidence for the formation of solid solutions over the full range from 0 to 1 for x and y. The same plot in Fig. 9B for Na₁₋ₓKₓScSi₂O₆ indicates that for the higher K fractions no solid solution is realized.

FIGs 3A and 3B, Figs 5A and 5B and Fig 9A illustrate the effect of composition on the emission properties of fluorescent materials. Close inspection reveals changes in emission peak position and width (FWHM), which is more clearly visible in FIGs 5A-B.

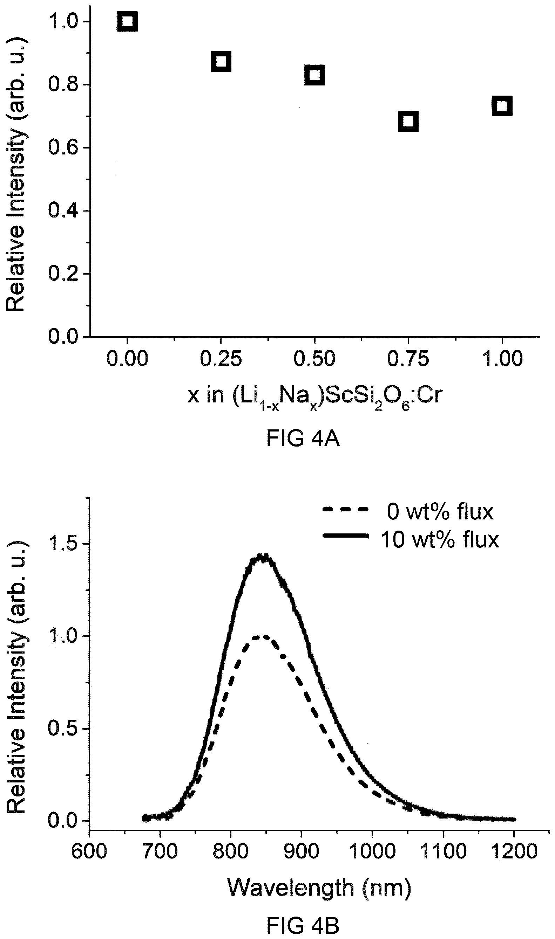

FIG 3A depicts the effect on composition on normalized peak width for NaₓLi₁₋ₓScSi₂O₆:5%Cr³⁺ solutions, wherein x is varying from 0 to 1 and in Fig. 9A for Na₁₋ₓKₓScSi₂O₆:5%Cr³⁺ and Li₁₋ₓKₓScSi₂O₆:5%Cr³⁺. FIGs 5A and 5B depict the effect on composition on normalized peak width for LiSc(Si_{1-y}Ge_{y})₂O₆:5%Cr³⁺ solutions, wherein y is varying from 0 to 1. As can be concluded from these figures, solutions comprising mixtures of alkali metals and/or mixtures of Si/Ge surprisingly revealed broadening of the emission peak with the maximum broadening between about 0.4 and 0.8. FIG 5A depicts normalized exemplary emission spectra for solid solutions with varying Si/Ge ratios. FIG 4A reveals that relative emission intensity at maximum emission for solid solutions of the type NaₓLi₁₋ₓScSi₂O₆:5%Cr³⁺ gradually decreases by about 20% as the x (sodium content) increases from 0 to 1.

To investigate the effect of addition of flux various chromium doped solid solutions with varying alkali metal content according to the invention were prepared in the presence of a flux. Tested fluxes include LiF, LiCl, NaF, NaCl, H₃BO₃, NH₄F. In each case addition of flux was found to improve homogeneity of formed particles (in terms of size and size distribution). Additionally, addition of flux was found to have a pronounced effect on emission efficiency. Addition of 10 at% of LiF was found to result in an increased emission efficiency. FIG 4B depicts exemplary emission spectra of NaₓLi₁₋ₓScSi₂O₆:5%Cr³⁺ solutions that were prepared and tested under identical conditions but that differ in the addition of flux. As can be seen addition of flux significantly increases emission intensity.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A light emitting device (1) comprising:
a light source (2); and
a fluorescent material (3) having a composition:
Li₁₋ₓM^{I}ₓSc_{1-a-b}CrₐM^{II}_{b}(Si_{1-y}Ge_{y})₂O₆,
wherein "M^{I}" represents at least one element selected from the group consisting of Na and K,
wherein "M^{II}" represents at least one element selected from the group consisting of Ti, V, In, Ga, Y, Lu, Ce, Eu, La and Gd,
wherein "a" and "b" each individually are 0.03 ≤ a ≤ 0.2, 0 ≤ b ≤ 0.8, and
wherein "x" and "y" each individually are 0.1 ≤ x ≤ 0.9, 0.1 ≤ y ≤ 0.9.

2. The light emitting device according to claim 1, wherein "x" is 0.4 ≤ x ≤ 0.8.

3. The light emitting device according to claim 1 or 2, wherein "y" is 0.4 ≤ y ≤ 0.9.

4. The light emitting device according to any one of the preceding claims 1 to 3, wherein "a+b" is 0.2 ≤ a+b ≤ 0.6.

5. The light emitting device according to any one of the preceding claims 1 to 4, wherein the fluorescent material is dispersed within a silicone matrix applied onto the light source.

6. The light emitting device according to any one of the preceding claims 1 to 5, wherein a cross-section diameter of the fluorescent material is between 5 and 20 micrometers.

7. The light emitting device according to any one of the preceding claims 1 to 6, wherein the light source comprises an InGaN light emitting diode.

8. A method of manufacturing a light emitting device, the method comprising:
preparing a fluorescent material in a process comprising:
providing a mixture of precursor material powders for forming the fluorescent material (3) having a composition:
Li₁₋ₓM^{I}ₓSc_{1-a-b}CrₐM^{II}_{b}(Si_{1-y}Ge_{y})₂O₆,
wherein "M^{I}" represents at least one element selected from the group consisting of Na and K,
wherein "M^{II}" represents at least one element selected from the group consisting of Ti, V, In, Ga, Y, Lu, Ce, Eu, La and Gd, and
wherein "a" and "b" each individually are 0.03 ≤ a ≤ 0.2, 0 ≤ b ≤ 0.8, and wherein "x" and "y" each individually are 0.1 ≤ x ≤ 0.9, 0.1 ≤ y ≤ 0.9, and
a firing step that comprises heating the mixture to a temperature in a range between 1000 °C and 1400 °C to form the fluorescent material (3); and
applying the prepared fluorescent material in a device comprising a light source configured to emit blue to near UV light, wherein the applied fluorescent material is configured to convert the blue to near UV light into NIR light.

9. The method of manufacturing the light emitting device according to claims 8, wherein the step of providing a mixture of precursor material powders comprises adding a flux agent.

10. The method of manufacturing the light emitting device according to claims 8 or 9, wherein the process for preparing the fluorescent material comprises an initial firing step prior to the firing step comprising heating the mixture to a temperature in a range between 700 °C and 1000 °C.

11. The method of manufacturing the light emitting device according to any one of the preceding claims 9 to 10, wherein the flux agent is LiF, added in an amount between 5 and 15 atomic percent excess.

12. The method of manufacturing the light emitting device according to any one of the preceding claim 10 or 11, wherein the process for preparing the fluorescent material comprises a milling or grinding step between the firing step and the initial firing step.

13. A trivalent chromium doped fluorescent material having an overall composition:
Li₁₋ₓM^{I}ₓSc_{1-a-b}CrₐM^{II}_{b}(Si_{1-y}Ge_{y})₂O₆,
wherein "M^{I}" represents a monovalent alkali cation or mixture of monovalent alkali cations selected from Na and K,
wherein "M^{II}" represents at least one element selected from the group consisting of Ti, V, In, Ga, Y, Lu, Ce, Eu, La and Gd,
wherein "x" and "y" each individually are 0.03 ≤ a ≤ 0.2, 0 ≤ b ≤ 0.8, and
wherein "x" and "y" each individually are 0.1 ≤ x ≤ 0.9, 0.1 ≤ y ≤ 0.9.

14. The trivalent chromium doped fluorescent material according to claim 13, wherein a cross-section diameter of the fluorescent material is between 5 and 20 micrometers.

15. A spectroscopy system comprising
the light emitting device (1) according to any one of the preceding claims 1 to 7; and
a NIR light detector configured to measure a spectrum of the NIR light produced by the light emitting device (1), or an object illuminated by the light emitting device.

## Patentansprüche

1. Licht emittierende Vorrichtung (1), umfassend:
eine Lichtquelle (2); und
ein fluoreszierendes Material (3), das eine Zusammensetzung aufweist:
Li₁₋ₓM^{I}ₓSc_{1-a-b}CrₐM^{II}_{b}(Si_{1-y}Ge_{y})₂O₆,
wobei "M^{I}" mindestens ein Element darstellt, das aus der Gruppe ausgewählt ist, die aus Na und K besteht,
wobei "M^{II}" mindestens ein Element darstellt, das aus der Gruppe ausgewählt ist, die aus Ti, V, In, Ga, Y, Lu, Ce, Eu, La und Gd besteht,
wobei "a" und "b" jeweils einzeln 0,03 ≤ a ≤ 0,2, 0 ≤ b ≤ 0,8, sind, und
wobei "x" und "y" jeweils einzeln 0,1 ≤ x ≤ 0,9, 0,1 ≤ y < 0,9 sind.

2. Licht emittierende Vorrichtung nach Anspruch 1, wobei "x" 0,4 ≤ x ≤ 0,8 ist.

3. Licht emittierende Vorrichtung nach Anspruch 1 oder 2, wobei "y" 0,4 ≤ y ≤ 0,9 ist.

4. Licht emittierende Vorrichtung nach einem der vorstehenden Ansprüche 1 bis 3, wobei "a+b" 0,2 ≤ a+b ≤ 0,6 ist.

5. Licht emittierende Vorrichtung nach einem der vorstehenden Ansprüche 1 bis 4, wobei das fluoreszierende Material innerhalb einer Silikonmatrix, die auf die Lichtquelle aufgebracht ist, dispergiert ist.

6. Licht emittierende Vorrichtung nach einem der vorstehenden Ansprüche 1 bis 5, und wobei ein Querschnittdurchmesser des fluoreszierenden Materials zwischen 5 und 20 Mikrometer liegt.

7. Licht emittierende Vorrichtung nach einem der vorstehenden Ansprüche 1 bis 6, wobei die Lichtquelle eine InGaN-Leuchtdiode umfasst.

8. Verfahren zum Herstellen einer Licht emittierenden Vorrichtung, wobei das Verfahren Folgendes umfasst:
Zubereiten eines fluoreszierenden Materials in einem Prozess, der Folgendes umfasst:
Bereitstellen einer Mischung aus Vorläufermaterialpulvern zum Bilden des fluoreszierenden Materials (3), das eine Zusammensetzung aufweist:
Li₁₋ₓM^{I}ₓSc_{1-a-b}CrₐM^{II}_{b}(Si_{1-y}Ge_{y})₂O₆,
wobei "M^{I}" mindestens ein Element darstellt, das aus der Gruppe ausgewählt ist, die aus Na und K besteht,
wobei "M^{II}" mindestens ein Element darstellt, das aus der Gruppe ausgewählt ist, die aus Ti, V, In, Ga, Y, Lu, Ce, Eu, La und Gd besteht, und
wobei "a" und "b" jeweils einzeln 0,03 ≤ a ≤ 0,2, 0 ≤ b ≤ 0,8, sind, und
wobei "x" und "y" jeweils einzeln 0,1 ≤ x ≤ 0,9, 0,1 ≤ y ≤ 0,9 sind, und
einen Brennschritt, der das Erhitzen der Mischung auf eine Temperatur in einem Bereich zwischen 1000 °C und 1400 °C zum Bilden des fluoreszierenden Materials (3) umfasst; und
Aufbringen des zubereiteten fluoreszierenden Materials in einer Vorrichtung, die eine Lichtquelle umfasst, die dazu konfiguriert ist blaues bis Nahe-UV-Licht zu emittieren, wobei das aufgebrachte fluoreszierende Material dazu konfiguriert ist, das blaue bis Nahe-UV-Licht in NIR-Licht umzuwandeln.

9. Verfahren zum Herstellen der Licht emittierenden Vorrichtung nach Anspruch 8, wobei der Schritt des Bereitstellens einer Mischung aus Vorläufermaterialpulvern das Zusetzen eines Flussmittels umfasst.

10. Verfahren zum Herstellen der Licht emittierenden Vorrichtung nach den Ansprüchen 8 oder 9, wobei der Prozess zum Zubereiten des fluoreszierenden Materials, der einen anfänglichen Brennschritt vor dem Brennschritt umfasst, der das Erhitzen der Mischung auf eine Temperatur in einem Bereich zwischen 700 °C und 1000 °C umfasst.

11. Verfahren zum Herstellen der Licht emittierenden Vorrichtung nach einem der vorstehenden Ansprüche 9 bis 10, wobei das Flussmittel LiF ist, das in einer Menge zwischen 5 und 15 Atomprozent Überschuss zugesetzt wird.

12. Verfahren zum Herstellen der Licht emittierenden Vorrichtung nach einem der vorstehenden Ansprüche 10 oder 11, wobei der Prozess zum Zubereiten des fluoreszierenden Materials einen Mahl- oder Schleifschritt zwischen dem Brennschritt und dem anfänglichen Brennschritt umfasst.

13. Mit dreiwertigem Chrom dotiertes fluoreszierendes Material, das eine Gesamtzusammensetzung umfasst:
Li₁₋ₓM^{I}ₓSc_{1-a-b}CrₐM^{II}_{b}(Si_{1-y}Ge_{y})₂O₆,
wobei "M^{I}" ein einwertiges Alkali-Kation oder eine Mischung einwertiger Alkali-Kationen, die aus Na und K ausgewählt sind, darstellt,
wobei "M^{II}" mindestens ein Element darstellt, das aus der Gruppe ausgewählt ist, die aus Ti, V, In, Ga, Y, Lu, Ce, Eu, La und Gd besteht,
wobei "x" und "y" jeweils einzeln 0,03 ≤ a ≤ 0,2, 0 ≤ b ≤ 0,8, sind, und
wobei "x" und "y" jeweils einzeln 0,1 ≤ x ≤ 0,9, 0,1 ≤ y ≤ 0,9 sind.

14. Mit dreiwertigem Chrom dotiertes fluoreszierendes Material nach Anspruch 13, wobei ein Querschnittdurchmesser des fluoreszierenden Materials zwischen 5 und 20 Mikrometer liegt.

15. Spektroskopiesystem, umfassend
die Licht emittierende Vorrichtung (1) nach einem der vorstehenden Ansprüche 1 bis 7; und
einen NIR-Lichtdetektor, der dazu konfiguriert ist, ein Spektrum des NIR-Lichts, das von der Licht emittierenden Vorrichtung (1) erzeugt wird, zu messen.

## Revendications

1. Dispositif électroluminescent (1), comprenant :
une source de lumière (2) ; et
un matériau fluorescent (3) présentant une composition :
Li₁₋ₓM^{I}ₓSc_{1-a-b}CrₐM^{II}_{b}(Si_{1-y}Ge_{y})₂O₆,
dans lequel « M^{I} » représente au moins un élément choisi dans le groupe comprenant Na et K,
dans lequel « M^{II} » représente au moins un élément choisi dans le groupe comprenant Ti, V, In, Ga, Y, Lu, Ce, Eu, La et Gd,
dans lequel « a » et « b » sont chacun individuellement 0,03 ≤ a ≤ 0,2, 0 ≤ b ≤ 0,8, et
dans lequel « x » et « y » sont chacun individuellement 0,1 ≤ x ≤ 0,9, 0,1 ≤ y ≤ 0,9.

2. Dispositif électroluminescent selon la revendication 1, dans lequel « x » est 0,4 ≤ x ≤ 0,8.

3. Dispositif électroluminescent selon la revendication 1 ou 2, dans lequel « y » est 0,4 ≤ y ≤ 0,9.

4. Dispositif électroluminescent selon l'une quelconque des revendications précédentes 1 à 3, dans lequel « a + b » est 0,2 ≤ a + b ≤ 0,6.

5. Dispositif électroluminescent selon l'une quelconque des revendications précédentes 1 à 4, dans lequel le matériau fluorescent est dispersé à l'intérieur d'une matrice de silicone appliquée sur la source de lumière.

6. Dispositif électroluminescent selon l'une quelconque des revendications précédentes 1 à 5, dans lequel un diamètre de section transversale du matériau fluorescent est compris entre 5 et 20 micromètres.

7. Dispositif électroluminescent selon l'une quelconque des revendications précédentes 1 à 6, dans lequel la source de lumière comprend une diode électroluminescente de InGaN.

8. Procédé de fabrication d'un dispositif électroluminescent, le procédé comprenant les étapes consistant à :
préparer un matériau fluorescent dans un processus comprenant les étapes consistant à :
fournir un mélange de poudres de matériau précurseur pour former le matériau fluorescent (3) présentant une composition :
Li₁₋ₓM^{I}ₓSc_{1-a-b}CrₐM^{II}_{b}(Si_{1-y}Ge_{y})₂O₆,
dans lequel « M^{I} » représente au moins un élément choisi dans le groupe comprenant Na et K,
dans lequel « M^{II} » représente au moins un élément choisi dans le groupe comprenant Ti, V, In, Ga, Y, Lu, Ce, Eu, La et Gd, et
dans lequel « a » et « b » sont chacun individuellement 0,03 ≤ a ≤ 0,2, 0 ≤ b ≤ 0,8, et
dans lequel « x » et « y » sont chacun individuellement 0,1 ≤ x ≤ 0,9, 0,1 ≤ y ≤ 0,9, et
une étape de cuisson qui comprend le chauffage du mélange à une température dans une plage allant de 1 000°C à 1 400°C pour former le matériau fluorescent (3) ; et
appliquer le matériau fluorescent préparé dans un dispositif comprenant une source de lumière configurée pour émettre une lumière bleue à UV proche, dans lequel le matériau fluorescent appliqué est configuré pour convertir la lumière bleue à UV proche en lumière NIR.

9. Procédé de fabrication du dispositif électroluminescent selon la revendication 8, dans lequel l'étape consistant à fournir un mélange de poudres de matériau précurseur comprend l'ajout d'un agent d'écoulement.

10. Procédé de fabrication du dispositif électroluminescent selon la revendication 8 ou 9, dans lequel le procédé de préparation du matériau fluorescent comprend une étape de cuisson initiale avant l'étape de cuisson comprenant le chauffage du mélange à une température comprise entre 700°C et 1 000°C.

11. Procédé de fabrication du dispositif électroluminescent selon l'une quelconque des revendications précédentes 9 à 10, dans lequel l'agent d'écoulement est du LiF, ajouté en une quantité comprise entre 5 et 15 pour cent atomique en excès.

12. Procédé de fabrication du dispositif électroluminescent selon l'une quelconque des revendications 10 ou 11 précédentes, dans lequel le processus de préparation du matériau fluorescent comprend une étape de meulage ou de broyage entre l'étape de cuisson et l'étape de cuisson initiale.

13. Matériau fluorescent dopé au chrome trivalent présentant une composition globale :
Li₁₋ₓM^{I}ₓSc_{1-a-b}CrₐM^{II}_{b}(Si_{1-y}Ge_{y})₂O₆,
dans lequel « M^{I}» représente un cation alcalin monovalent ou un mélange de cations alcalins monovalents choisis parmi Na et K,
dans lequel « M^{II} » représente au moins un élément choisi dans le groupe comprenant Ti, V, In, Ga, Y, Lu, Ce, Eu, La et Gd,
dans lequel « x » et « y » sont chacun individuellement 0,03 ≤ a ≤ 0,2, 0 ≤ b ≤ 0,8, et
dans lequel « x » et « y » sont chacun individuellement 0,1 ≤ x ≤ 0,9, 0,1 ≤ y ≤ 0,9.

14. Matériau fluorescent dopé au chrome trivalent selon la revendication 13, dans lequel un diamètre de section transversale du matériau fluorescent est compris entre 5 et 20 micromètres.

15. Système de spectroscopie, comprenant
le dispositif électroluminescent (1) selon l'une quelconque des revendications 1 à 7 ; et
un détecteur de lumière NIR configuré pour mesurer un spectre de la lumière NIR produite par le dispositif électroluminescent (1), ou un objet éclairé par le dispositif électroluminescent.
